# EUROPEAN PATENT APPLICATION

(11) **EP 3 299 173 A1**
(43) Date of publication of application: **28.03.2018**
(21) Application number: 17192994.6
(22) Date of filing: 25.09.2017
(51) Int. Cl.: B41J 2/16

(54) **METHOD FOR MANUFACTURING EJECTION HOLE PLATE**

(30) Priority: 26.09.2016 JP 2016186455
(71) Applicant: SII Printek Inc, Chiba-shi, Chiba (JP)
(72) Inventor: IROKAWA, Daiki, Chiba-shi, Chiba (JP)
(74) Representative: Miller Sturt Kenyon

(57) **Abstract**

A method for manufacturing a nozzle plate is a method for manufacturing a nozzle plate with nozzle holes for ejecting an ink. The method includes: a hole making process for making a plurality of holes to be the nozzle holes in a base material for the nozzle plate; and a repair process for repairing a defective hole, out of the plurality of holes, in which a hole diameter of a portion to be a downstream opening along a direction of ink flow is smaller than a desired hole diameter. In the repair process, the defective hole is processed to have a hole with a repaired hole diameter of the portion to be the downstream opening smaller than the desired hole diameter and larger than the hole diameter of the defective hole.

## Description

### BACKGROUND

### Technical Field

The present invention relates to a method for manufacturing an ejection hole plate.

### Related Art

There is conventionally an inkjet printer including an inkjet head as an apparatus that discharges ink droplets onto a recording medium such as recording paper or the like to record images, characters, and the like on the recording medium. The inkjet head has an actuator plate with channels to be charged with an ink and a nozzle plate with nozzle holes communicating with the channels. In the inkjet head, the actuator plate deforms in such a manner to increase and decrease the volume of the discharge channel to discharge the ink charged in the discharge channels through the nozzle holes.

There are methods for forming nozzle holes in the nozzle plate by which work is irradiated with laser light from a predetermined direction to form nozzle holes as described in JP 2007-203650 A, for example, or etching is carried out to form nozzle holes.

### SUMMARY

However, when the nozzle holes are formed by laser processing by a technique as disclosed in JP 2007-203650 A, for example, if the base material contains any foreign matter, the laser light may be blocked by the foreign matter so that the nozzle holes cannot be formed in the desired shape. In addition, when the nozzle holes are formed by etching, if foreign matter resides on a photomask for forming an etching mask from a photoresist material, the foreign matter may be transferred to the etching mask so that the nozzle holes cannot be formed in the desired shape.

When the nozzle holes cannot be formed in the desired shape as stated above, and the downstream openings of the nozzle holes are smaller in diameter than desired in particular, the direction of ink discharge may be changed (deflected) from the desired direction. This results in degradation of imaging quality of the inkjet head. Therefore, there is an issue of reducing variations in diameter of the nozzle holes to stabilize the direction of ink discharge in conventional techniques.

An object of the present invention is to provide a method for manufacturing an ejection hole plate so as to reduce variations in the hole diameter among the ejection holes.

The present invention provides a method for manufacturing an ejection hole plate with ejection holes for ejecting a liquid, including: a hole making process for making a plurality of holes to be the ejection holes in a base material for the ejection hole plate; and a repair process for repairing a defective hole out of the plurality of holes, in which a hole diameter of a portion to be a downstream opening along a flow direction of the liquid is smaller than a desired hole diameter, in which in the repair process, the defective hole is processed to have a hole with a repaired hole diameter of the portion to be the downstream opening smaller than the desired hole diameter and larger than the hole diameter of the defective hole.

According to the present invention, in the repair process, the defective hole is processed to have the hole with the repaired hole diameter larger than the defective hole. This makes it possible to repair the defective hole such that the hole diameter of the portion to be the downstream opening of the defective hole comes close to the desired hole diameter. In addition, in the repair process, the defective hole is processed to have the hole with the repaired hole diameter smaller than the desired hole diameter. Accordingly, even though the hole making position is shifted from the desired position, it is possible to suppress the situation in which the portion to be the downstream opening of the defective hole has a diameter larger than the desired hole diameter. This reduces variations in the hole diameter among the ejection holes.

In the method for manufacturing an ejection hole plate, it is desirable that the hole making process and the repair process are carried out by laser processing.

According to the present invention, there is no need to form an etching mask, which facilitates the hole making process and the repair process, unlike the method in which to make holes by etching. This reduces the costs for manufacturing the ejection hole plate.

In the method for manufacturing an ejection hole plate, it is desirable that, in the repair process, the base material is irradiated with laser light as parallel beams.

According to the present invention, there is no need to adjust the focus position of the laser light on the base material that would be necessary in the case of emitting diverged or converged laser light. This facilitates the repair process. Therefore, the costs for manufacturing the ejection hole plate can be reduced.

In the method for manufacturing an ejection hole plate, it is desirable that, in the repair process, the base material is irradiated from a downstream side in the flow direction with laser light of which beam diameter gradually increases toward a downstream side in a direction of beam emission.

According to the present invention, in the case of forming tapered holes decreased in diameter toward the downstream side along the direction of liquid flow, the laser light can be applied to the defective hole along its inner surface. Accordingly, the defective hole can be repaired so as to come closer to the desired shape. Therefore, it is possible to further reduce variations in hole diameter among the ejection holes.

The method for manufacturing an ejection hole plate desirably includes an inspection process for detecting the defective hole between the hole making process and the repair process.

According to the present invention, only the defective hole detected in the inspection process is repaired in the repair process. Therefore, the repair process can be efficiently carried out to reduce the costs for manufacturing the ejection hole plate.

In the method for manufacturing an ejection hole plate, it is desirable that the repair process includes: a repair etching mask formation step of forming a repair etching mask having a mask opening with the repaired hole diameter at a portion corresponding to the defective hole in the base material; and a repair etching step of etching the base material through the repair etching mask.

According to the present invention, the base material is etched through the repair etching mask having the mask opening with the repaired hole diameter, so that the defective hole can be repaired in such a manner as to bring the hole diameter of the portion to be the downstream opening of the defective hole closer to the desired hole diameter. Therefore, it is possible to reduce variations in hole diameter among the ejection holes.

According to the present invention, in the repair process, the defective hole is processed to have the hole with the repaired hole diameter larger than the hole diameter of the defective hole, so that the defective hole can be repaired in such a manner as to bring the hole diameter of the portion to be the downstream opening of the defective hole closer to the desired hole diameter. In addition, in the repair process, the defective hole is processed to have the hole with the repaired hole diameter smaller than the desired hole diameter. Accordingly, even though the hole making position is shifted from the desired position, it is possible to suppress the situation in which the portion to be the downstream opening of the defective hole is larger than the desired hole diameter. Therefore, it is possible to reduce variations in the hole diameter among the ejection holes.

### BRIEF DESCRIPTION OF DRAWINGS

Embodiments of the present invention will now be described by way of further example only and with reference to the accompanying drawings, in which:
FIG. 1 is a schematic configuration diagram of a printer according to a first embodiment;
FIG. 2 is a perspective view of an inkjet head according to the first embodiment;
FIG. 3 is a perspective view of a head chip according to the first embodiment;
FIG. 4 is an exploded perspective view of the head chip according to the first embodiment;
FIG. 5 is a process diagram for describing a method for manufacturing a nozzle plate according to the first embodiment;
FIG. 6 is a process diagram for describing the method for manufacturing a nozzle plate according to the first embodiment;
FIG. 7 is a process diagram for describing the method for manufacturing a nozzle plate according to the first embodiment;
FIG. 8 is a process diagram for describing the method for manufacturing a nozzle plate according to the first embodiment;
FIG. 9 is a process diagram for describing the method for manufacturing a nozzle plate according to the first embodiment;
FIG. 10 is a process diagram for describing the method for manufacturing a nozzle plate according to the first embodiment;
FIG. 11 is a process diagram for describing the method for manufacturing a nozzle plate according to a modification of the first embodiment;
FIG. 12 is a process diagram for describing the method for manufacturing a nozzle plate according to the modification of the first embodiment;
FIG. 13 is a process diagram for describing a method for manufacturing a nozzle plate according to a second embodiment;
FIG. 14 is a process diagram for describing the method for manufacturing a nozzle plate according to the second embodiment;
FIG. 15 is a process diagram for describing the method for manufacturing a nozzle plate according to the second embodiment;
FIG. 16 is a process diagram for describing the method for manufacturing a nozzle plate according to the second embodiment;
FIG. 17 is a process diagram for describing the method for manufacturing a nozzle plate according to the second embodiment;
FIG. 18 is a process diagram for describing the method for manufacturing a nozzle plate according to the second embodiment; and
FIG. 19 is a process diagram for describing the method for manufacturing a nozzle plate according to the second embodiment.

### DETAILED DESCRIPTION

Embodiments of the present invention will be described below with reference to the drawings. In the following description of the embodiments, an inkjet printer (hereinafter, simply called printer) for making records on a recording medium using an ink (liquid) will be taken as an example. In the drawings referred to in the following description, the members are scaled as appropriate so that the members can be illustrated in recognizable sizes.

### [First Embodiment]

### (Printer)

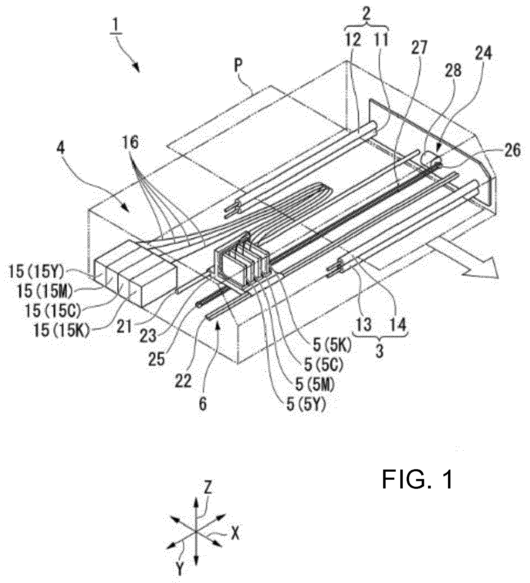

FIG. 1 is a schematic configuration diagram of a printer 1 of a first embodiment.

As illustrated in FIG. 1, the printer 1 of the embodiment includes a pair of conveying mechanisms 2 and 3, an ink supply mechanism 4, inkjet heads 5, and a scanning mechanism 6. In the following description, an orthogonal coordinate system of X, Y, and Z will be used as necessary. In this case, an X direction is aligned with the direction in which a recording medium P (for example, paper or the like) is conveyed, a Y direction is aligned with the direction in which the scanning mechanism 6 scans, and a Z direction is height direction orthogonal to the X direction and the Y direction.

The conveying mechanisms 2 and 3 convey the recording medium P in the X direction. Specifically, the conveying mechanism 2 includes a grit roller 11 extended in the Y direction, a pinch roller 12 extended in parallel to the grit roller 11, and a driving mechanism (not illustrated) such as a motor for axially rotating the grit roller 11. Similarly, the conveying mechanism 3 includes a grit roller 13 extended in the Y direction, a pinch roller 14 extended in parallel to the grit roller 13, and a driving mechanism (not illustrated) for axially rotating the grit roller 13.

The ink supply mechanism 4 includes ink tanks 15 storing inks and ink tubes 16 connecting the ink tanks 15 and the inkjet heads 5.

The ink tanks 15 are ink tanks 15Y, 15M, 15C, and 15K storing respective inks of four colors, for example, yellow, magenta, cyan, and black. In the embodiment, the ink tanks 15Y, 15M, 15C, and 15K are aligned in the X direction.

The ink tubes 16 are flexible hoses, for example. The ink tubes 16 connect individually between the ink tanks 15 and the inkjet heads 5.

The scanning mechanism 6 reciprocates the inkjet heads 5 for scanning in the Y direction. Specifically, the scanning mechanism 6 includes a pair of guide rails 21 and 22 extended in the Y direction, a carriage 23 movably supported by the pair of guide rails 21 and 22, and a driving mechanism 24 moving the carriage 23 in the Y direction.

The driving mechanism 24 is interposed between the guide rails 21 and 22 along the X direction. The driving mechanism 24 includes a pair of pulleys 25 and 26 spaced in the Y direction, an endless belt 27 wound around the pair of pulleys 25 and 26, and a driving motor 28 rotationally driving the one pulley 25.

The carriage 23 is coupled to the endless belt 27. The carriage 23 is loaded with the plurality of inkjet heads 5 aligned in the Y direction. In the embodiment, the inkjet heads 5 are inkjet heads 5Y, 5M, 5C, and 5K to discharge respective inks of four colors, yellow, magenta, cyan, and black.

### (Inkjet head)

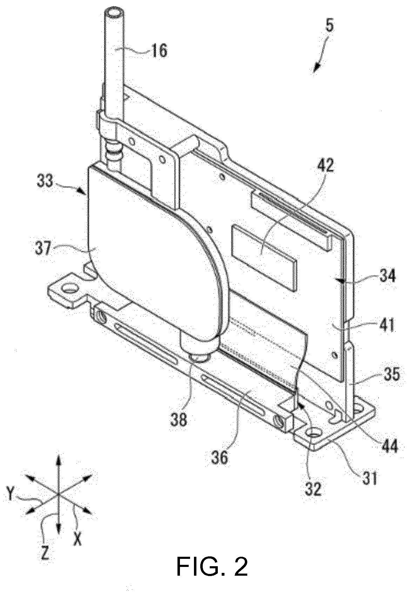

FIG. 2 is a perspective view of an inkjet head according to the first embodiment. The inkjet heads 5Y, 5M, 5C, and 5K are configured in the same manner except for the color of the supplied ink. Thus, these inkjet heads will be collectively described below as inkjet head 5.

As illustrated in FIG. 2, the inkjet head 5 includes a fixation plate 31 fixed to the carriage 23, a head chip 32 fixed to the fixation plate 31, an ink supply unit 33 that supplies the ink from the ink supply mechanism 4 to the head chip 32, and a control unit 34 that applies a drive voltage to the head chip 32.

A base plate 35 is fixed to and erected from the fixation plate 31 in the Z direction.

The ink supply unit 33 mainly includes a flow path member 36 fixed to the fixation plate 31, a pressure damper 37 fixed to the base plate 35, and an ink coupling tube 38 connecting between the flow path member 36 and the pressure damper 37.

The ink tube 16 is connected to the pressure damper 37. When being supplied with the ink via the ink tube 16, the pressure damper 37 reserves the ink therein temporarily. The pressure damper 37 then supplies the reserved ink to the head chip 32 via the ink coupling tube 38 and the flow path member 36.

The control unit 34 has mainly an IC substrate 41 fixed to the base plate 35 and a control circuit 42 mounted on the IC substrate 41.

The control circuit 42 has an integrated circuit and the like to drive the head chip 32. The control circuit 42 is electrically connected to the head chip 32 via a flexible printed substrate 44 on which a wiring pattern not illustrated is printed.

### (Head chip)

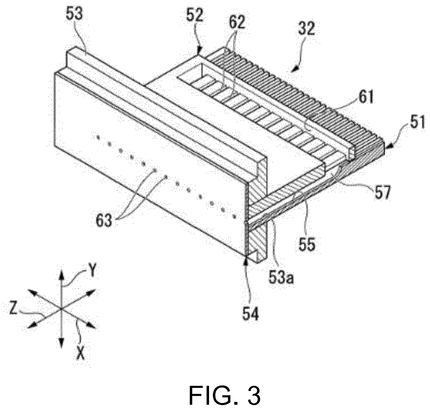

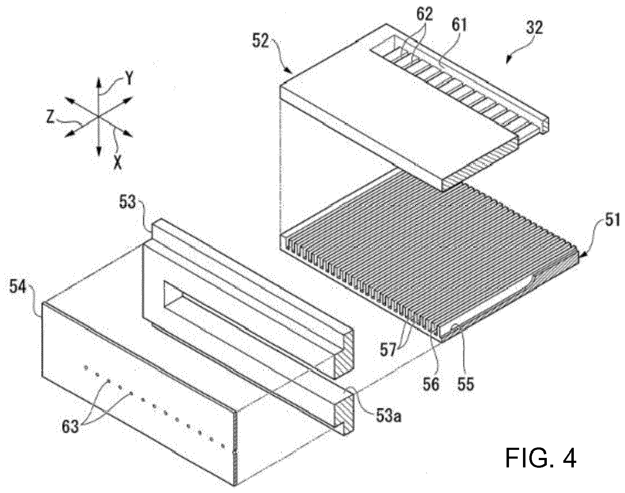

FIG. 3 is a perspective view of the head chip according to the first embodiment. FIG. 4 is an exploded perspective view of the head chip according to the first embodiment.

The head chip 32 illustrated in FIGS. 3 and 4 is an edge shoot type that discharges an ink from ends of discharge channels 55 described later along the extending direction (Z direction). Specifically, the head chip 32 includes an actuator plate 51, a cover plate 52, a support plate 53, and a nozzle plate (ejection hole plate) 54. In the following description, the cover plate 52 side along the Y direction is designated as front side and the actuator plate 51 side along the Y direction as back side. In addition, the nozzle plate 54 side along the Z direction is designated as downward side and the side opposite to the nozzle plate 54 as upward side.

The actuator plate 51 includes a monopole substrate in which the direction of polarization is set to one along the thickness direction (Y direction). The actuator plate 51 is preferably formed from a ceramic substrate made of lead zirconate titanate (PZT) or the like, for example. Alternatively, the actuator plate 51 may be formed by stacking two piezoelectric substrates different in the direction of polarization in the Z direction (chevron type).

The actuator plate 51 has a plurality of channels 55 and 56 spaced in the X direction on the front surface. The channels 55 and 56 are formed linearly along the Z direction. Therefore, the channels 55 and 56 are divided in the X direction by drive walls 57 composed of the actuator plate 51.

The plurality of channels 55 and 56 constitutes discharge channels 55 to be filled with the ink and non-discharge channels 56 not to be filled with the ink (see FIG. 4). The discharge channels 55 and the non-discharge channels 56 are alternately aligned in the X direction. Drive electrodes not illustrated are formed by deposition or the like on the inner surfaces of the channels 55 (drive walls 57). With application of a drive voltage via the flexible printed substrate 44 (see FIG. 2), the drive electrodes deform the drive walls 57 by piezoelectric shear effect.

The cover plate 52 is formed in a rectangular shape in a plane view seen from the Y direction. The cover plate 52 is bonded to the front surface of the actuator plate 51 with the upper end portion of the actuator plate 51 exposed.

The cover plate 52 has a common ink chamber 61 formed on the front surface and a plurality of slits 62 formed on the back surface.

The common ink chamber 61 is formed at a position corresponding to the upper ends of the discharge channels 55 in the Z direction. The common ink chamber 61 is recessed toward the back surface of the cover plate 52 and extended in the X direction. The ink flows into the common ink chamber 61 through the flow path member 36.

The slits 62 are formed in the common ink chamber 61 at positions opposed to the discharge channels 55 in the Y direction. The slits 62 allow the common ink chamber 61 to individually communicate with the discharge channels 55. The non-discharge channels 56 do not communicate with the common ink chamber 61.

The support plate 53 supports the actuator plate 51 and the cover plate 52 and also supports the nozzle plate 54 at the same time. The support plate 53 has a fitting hole 53a penetrating therethrough in the Z direction and extending along the X direction. The actuator plate 51 and the cover plate 52 are fitted into the fitting hole 53a and supported by the support plate 53 in that state.

The nozzle plate 54 is fixed by an adhesive or the like, for example, to the lower end surfaces of the actuator plate 51 and the cover plate 52. The nozzle plate 54 has nozzle holes (ejection holes) 63 penetrating therethrough in the Z direction. The ink flows through the nozzle holes 63 in the Z direction from the upper side to the lower side to eject the ink from the downstream openings. The nozzle holes 63 are tapered with gradual decrease in diameter from the upper side to the lower side. The nozzle holes 63 are individually formed in the nozzle plate 54 at respective positions opposed to the discharge channels 55 in the Z direction. That is, the plurality of nozzle holes 63 is spaced in the X direction. Accordingly, the discharge channels 55 communicate with the outside through the nozzle holes 63. Meanwhile, the non-discharge channels 56 are blocked with the nozzle plate 54. The nozzle plate 54 has a single-layer structure or a stacked structure of a resin material (polyimide or the like), a metallic material (SUS or the like), silicon, glass, or the like. The thickness of the nozzle plate 54 is about 50 µm, for example.

### (Method for operating printer)

Next, the use of the printer 1 for recording information on the recording medium P will be described below.

As illustrated in FIG. 1, when the printer 1 is operated, the grit rollers 11 and 13 in the conveying mechanisms 2 and 3 rotate to convey the recording medium P in the X direction between the grit rollers 11 and 13 and the pinch rollers 12 and 14. At the same time, the driving motor 28 rotates the pulley 26 to run the endless belt 27. Accordingly, the carriage 23 reciprocates in the Y direction while being guided by the guide rails 21 and 22.

In the meantime, in each of the inkjet heads 5, a drive voltage is applied to the drive electrodes on the head chips 32. Accordingly, the drive walls 57 undergo thickness shear deformation to generate a pressure wave in the ink charged in the discharge channels 55. The pressure wave increases the inner pressure in the discharge channels 55 and discharges the ink through the nozzle holes 63. Then, the ink lands on the recording medium P to record various kinds of information on the recording medium P.

### (Method for manufacturing nozzle plate)

Next, a method for manufacturing the nozzle plate 54 of the first embodiment will be described.

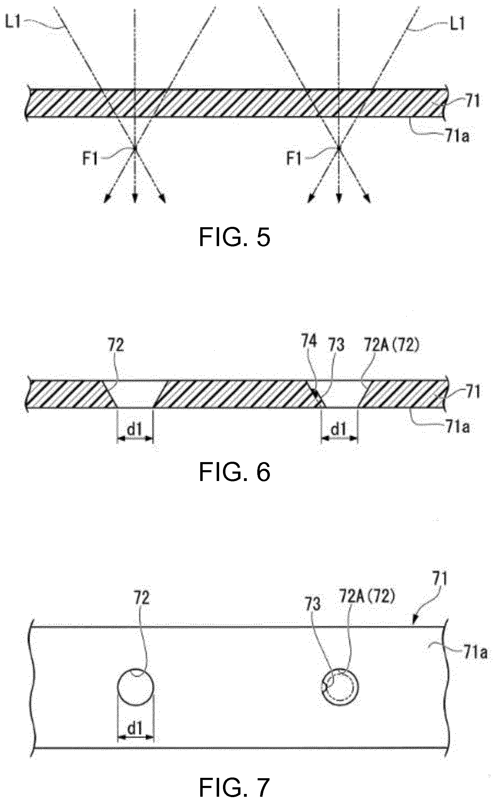

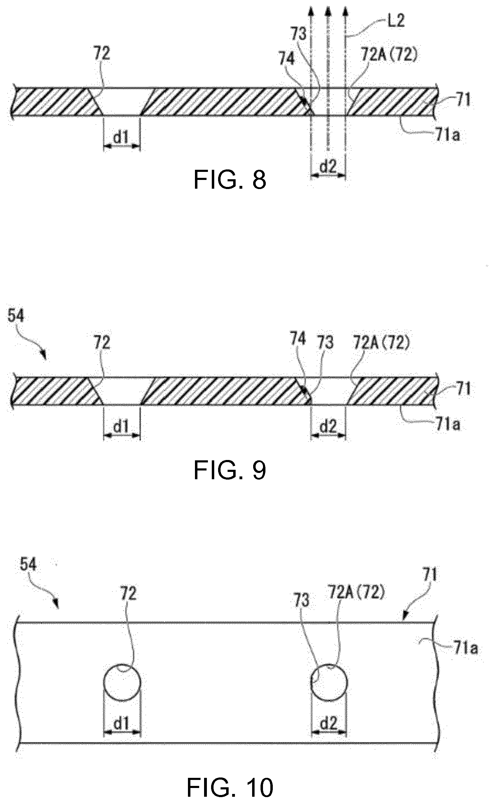

FIGS. 5 to 10 are process diagrams for describing the method for manufacturing the nozzle plate of the first embodiment. FIGS. 5, 6, 8, 9, 11, and 12 are cross-section views, and FIGS. 7 and 10 are plane views seen from underneath.

As illustrated in FIGS. 5 to 10, the method for manufacturing the nozzle plate 54 of the embodiment includes: a hole making process for making a plurality of holes 72 to be the nozzle holes 63 in a base material 71 for the nozzle plate 54; an inspection process for detecting, out of the plurality of holes 72, a defective hole 72A in which the hole diameter of a portion to be a downstream opening along the direction of ink flow (Z direction) (the hole diameter in a lower surface 71a of the base material 71) is smaller than a desired hole diameter d1; and a repair process for repairing the defective hole 72A. In the embodiment, a polyimide substrate is used as the base material 71 for the nozzle plate 54 as an example. In the following description, the vertical direction of the base material 71 coincides with the vertical direction of the nozzle plate 54 formed from the base material 71.

First, the hole making process is carried out.

As illustrated in FIGS. 5 and 6, in the hole making process, holes 72 are made by laser processing such that the hole diameter in the lower surface 71a of the base material 71 becomes the desired hole diameter d1. As illustrated in FIG. 5, the hole making process is carried out by irradiating the base material 71 with laser light L1 from above. The beam diameter of the laser light L1 gradually decreases from the upper side to lower side of the base material 71. Specifically, the base material 71 is irradiated with the converged laser light L1 from above such that a focus F1 is positioned below the base material 71. The laser light L1 is collected by a micro lens array or the like, for example.

Irradiating the base material 71 with the laser light L1 melts the portions of the base material 71 irradiated with the laser light L1 to make the holes 72 as illustrated in FIG. 6. Since the irradiated laser light L1 converges with gradual decrease in diameter from the upper side to lower side, the holes 72 are tapered with gradual decrease in diameter from the upper side to lower side. The base material 71 may be irradiated with the laser light L1 while the base material 71 is revolved around the optical axis of the laser light L1.

The base material 71 may contain foreign matter 74 such as silica. When the foreign matter 74 resides on the portion of the base material 71 where the hole 72 is to be formed, the laser light L1 is blocked with the foreign matter 74. As a result, the portion of the base material 71 positioned on the downstream side along the direction of emission of the laser light L1 beyond the foreign matter 74 becomes a residual portion 73 that remains unmelted. This results in the defective hole 72A of which the hole diameter of the portion to be the downstream opening of the hole 72 is smaller than the desired hole diameter d1 as illustrated in FIG. 7. The hole diameter of the defective hole 72A is the diameter of a circle as a desired opening shape of the hole 72 in the lower surface 71a of the base material 71, with a radius from the center to the residual portion 73 (circle indicated by a two-dot chain line in FIG. 7).

Next, the inspection process is carried out.

In the inspection process, the defective hole 72A is detected by image processing. Specifically, in the inspection process, the holes 72 are photographed from underneath by a CCD camera or the like to determine whether the shapes of the photographed holes 72 are desired ones.

Next, the repair process is carried out.

As illustrated in FIG. 8, in the repair process, a hole is made in the defective hole 72A detected in the inspection process such that the hole has a repaired hole diameter d2 of the portion to be the downstream opening smaller than the desired hole diameter d1 and larger than the hole diameter of the defective hole 72A. Specifically, in the repair process, the base material 71 is irradiated with laser light L2 from underneath. The laser light L2 constitutes parallel beams with a beam diameter constituting the repaired hole diameter d2. The laser light L2 is emitted to the defective hole 72A in such a manner as to be concentric with the defective hole 72A.

Accordingly, as illustrated in FIGS. 9 and 10, it is possible to remove the residual portion 73 in the defective hole 72A seen from underneath without having to process the portion of the defective hole 72A other than the residual portion 73.

According to the method for manufacturing the nozzle plate 54 of the embodiment, in the repair process, the hole with the repaired hole diameter d2 larger than the hole diameter of the defective hole 72A is made in the defective hole 72A to bring the hole diameter of the portion of the defective hole 72A to be the downstream opening close to the desired hole diameter d1. In addition, in the repair process, the hole with the repaired hole diameter d2 smaller than the desired hole diameter d1 is made in the defective hole 72A. Accordingly, even though the hole making position is shifted from the desired position, it is possible to suppress the situation in which the portion to be the downstream opening of the defective hole 72A is larger than the desired hole diameter d1. Therefore, it is possible to reduce variations in the hole diameter of the downstream openings of the nozzle holes 63 in the lower surface 71a. This stabilizes the direction of ink discharge and suppresses degradation in the imaging quality of the inkjet heads 5.

In the embodiment, the hole making process and the repair process are carried out by laser processing. According to this method, there is no need to form an etching mask, unlike the method in which holes are made by etching. This facilitates the hole making process and the repair process. Therefore, the costs for manufacturing the nozzle plate 54 can be reduced.

In the embodiment, the base material 71 is irradiated with the laser light L2 as parallel beams in the repair process. According to this method, there is no need to adjust the focal position of the laser light on the base material 71, which would be required in order to emit diverged or converged laser light. This facilitates the repair process. Therefore, the costs for manufacturing the nozzle plate 54 can be reduced.

In the embodiment, the inspection process is carried out to detect the defective hole 72A between the hole making process and the repair process. This allows only the defective hole detected in the inspection process to be repaired in the repair process. Accordingly, the repair process can be efficiently carried out, thereby reducing the costs for manufacturing the nozzle plate 54.

In the embodiment, the base material 71 is irradiated with the laser light L2 as parallel beams from underneath in the repair process. Alternatively, the base material 71 may be irradiated with the laser beam from above.

In the embodiment, the residual portion 73 is formed from the foreign matter 74 such as silica contained in the base material 71 as an example. The embodiment is also applicable to the case in which the laser light L1 is blocked with foreign matter or the like on the base material 71 to form the residual portion, for example.

In the embodiment, the inspection process is carried out between the hole making process and the repair process. However, the present invention is not limited to this and the inspection process need not be carried out. In this case, holes with the repaired hole diameter d2 are formed in all the holes 72 to repair the defective hole 72A in the repair process.

In the embodiment, a hole with the repaired hole diameter d2 is formed only in the defective hole 72A in the repair process, but the present invention is not limited to this. Alternatively, in the repair process, holes with the repaired hole diameter d2 may be formed in both the defective hole 72A and the holes 72 with the desired hole diameter d1 simultaneously. In this case, the repaired hole diameter d2 is smaller than the desired hole diameter d1 and thus the holes 72 with the desired hole diameter d1 are not processed in the repair process.

### [Modification of First Embodiment]

### (Method for manufacturing nozzle plate)

Next, a method for manufacturing the nozzle plate 54 according to a modification of the first embodiment will be described. The hole making process and the inspection process in the method for manufacturing the nozzle plate 54 according to the modification of the first embodiment are the same as those in the method for manufacturing the nozzle plate 54 according to the first embodiment, and descriptions thereof will be omitted.

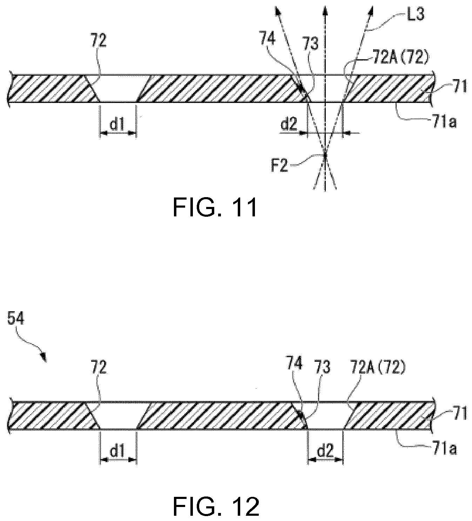

FIGS. 11 and 12 are process diagrams for describing the method for manufacturing the nozzle plate 54 according to the modification of the first embodiment.

In the repair process of the first embodiment illustrated in FIG. 8, the base material is irradiated with the laser light L2 as parallel beams. The modification of the first embodiment illustrated in FIG. 11 is different from the first embodiment in that, in the repair process, the base material 71 is irradiated with laser light L3 as divergent beams.

As illustrated in FIG. 11, in the repair process, the base material 71 is irradiated with the laser light L3 from underneath. The laser light L3 constitutes divergent beams with the beam diameter on the lower surface 71a of the base material 71 equal to the repaired hole diameter d2. Specifically, the beam diameter of the laser light L3 on the irradiated portion of the base material 71 gradually increases from the upstream side to downstream side in the direction of beam emission. The laser light L3 is applied to the base material 71 from underneath in the state of converging on a focal point F2 positioned under the base material 71. The laser light L3 is emitted to the defective hole 72A so as to be concentric with the defective hole 72A. Accordingly, as illustrated in FIG. 12, it is possible to remove the residual portion 73 in the defective hole 72A seen from underneath without having to process the portion of the defective hole 72A other than the residual portion 73. The divergence angle of the laser light L3 can be arbitrarily set as far as the laser light L3 is not applied to portions of the inner peripheral surfaces of the holes 72 formed in the desired shape.

According to the method for manufacturing the nozzle plate 54 of the modification example, in the repair process, the base material 71 is irradiated from underneath with the laser light L3 gradually increased in beam diameter toward the downstream side in the direction of beam emission. According to this method, in the case of forming the tapered holes 72 decreased in diameter toward the downstream side in the direction of ink flow, the laser light L3 can be applied to the defective hole 72A along its inner surface. This makes it possible to repair the defective hole 72A in such a manner as to be closer to the desired shape. Therefore, it is possible to further reduce variations in hole diameter among the nozzle holes 63.

### [Second Embodiment]

### (Method for manufacturing nozzle plate)

Next, a method for manufacturing the nozzle plate 54 according to a second embodiment will be described.

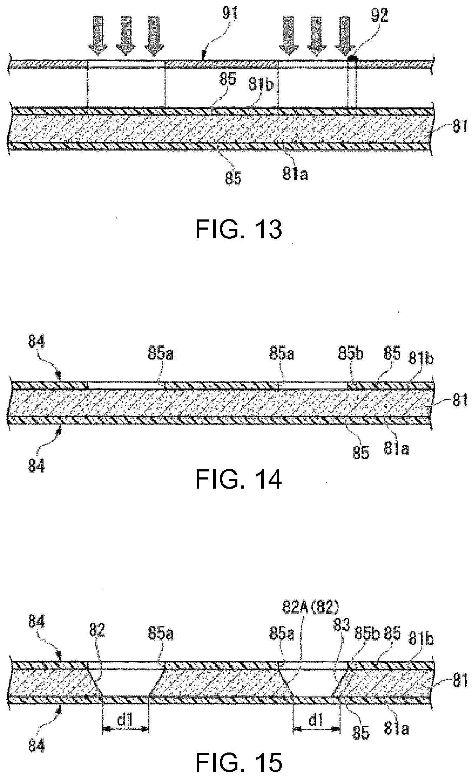

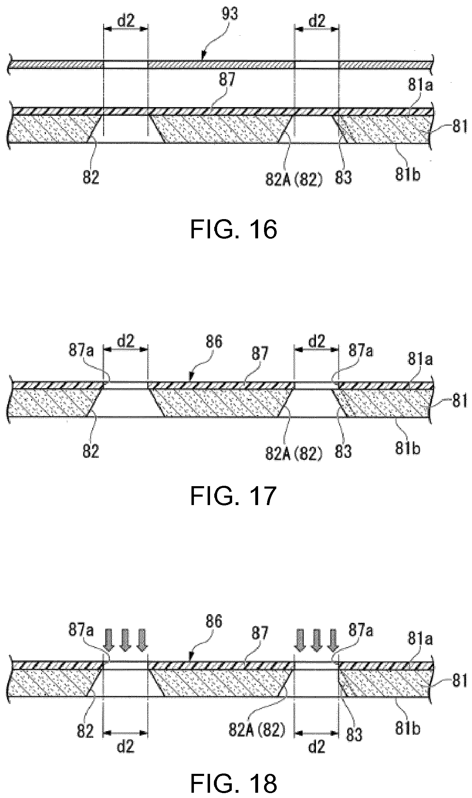

FIGS. 13 to 19 are process diagrams for describing the method for manufacturing the nozzle plate 54 according to the second embodiment. FIGS. 13 to 19 are cross-section views. FIGS. 16 to 19 are cross-section views that are vertically reversed from (upside down compared to) the cross-section views of FIGS. 13 to 15.

In the first embodiment illustrated in FIGS. 5 to 10, the hole making process and the repair process are carried out by laser processing. The second embodiment illustrated in FIGS. 13 to 19 is different from the first embodiment in that the hole making process and the repair process are carried out by etching.

As illustrated in FIGS. 13 to 20, the method for manufacturing the nozzle plate 54 of the embodiment includes: a hole making process for making a plurality of holes 82 to be the nozzle holes 63 in a base material 81 for the nozzle plate 54; and a repair process for repairing a defective hole 82A. In the embodiment, a single-crystal silicon substrate is used as the base material 81 for the nozzle plate 54 as an example.

First, the hole making process is carried out. As illustrated in FIGS. 13 to 16, the hole making process includes: an etching mask formation step of forming an etching mask 84 for nozzle hole formation on the front surface of the base material 81 for the nozzle plate 54; an etching step of etching the base material 81 through the etching mask 84; and a mask removal step of removing the etching mask 84.

First, the etching mask formation step is carried out.

As illustrated in FIG. 13, at the etching mask formation step, a photoresist film 85 is formed on both surfaces of the base material 81. Then, the photoresist film 85 on an upper surface 81b of the base material 81 is exposed to light using a photomask 91 for nozzle hole formation with circular light-exposing patterns corresponding to the nozzle holes 63. After that, the photoresist film 85 is developed to turn the photoresist film 85 into an etching mask 84 for nozzle hole formation with openings 85a corresponding to the nozzle holes 63 as illustrated in FIG. 14.

Next, the etching step is carried out.

As illustrated in FIG. 15, at the etching step, the base material 81 is etched with the etching mask 84. At the etching step, anisotropic etching is carried out using a wet etching technique. The amount of etching is set to a degree that the base material 81 is fully penetrated by etching. Accordingly, tapered holes 82 gradually decreased in diameter from the upper side to lower side are formed in the base material 81.

Next, the mask removal step is carried out.

At the mask removal step, the photoresist film 85 constituting the etching mask 84 is removed.

Accordingly, the hole making process is completed.

If any foreign matter 92 lies on the photomask 91 for nozzle hole formation at the etching mask formation step as illustrated in FIG. 13, the photoresist film 85 is not properly exposed to light. Accordingly, a variant portion 85b is formed in the opening 85a of the developed photoresist film 85 as illustrated in FIG. 14. As a result, the hole 82 formed by etching through the opening 85a with the variant portion 85b does not take the desired shape but has a residual portion 83 therein as illustrated in FIG. 15. Accordingly, the hole 82 becomes a defective hole 82A in which the hole diameter of a portion to be a downstream opening of the hole 82 is smaller than the desired hole diameter d1.

Next, the repair process is carried out. As illustrated in FIGS. 16 to 19, in the repair process, all the holes 82 including the defective hole 82A are processed to have holes with the repaired hole diameter d2 smaller than the desired hole diameter d1 and larger than the hole diameter of the defective hole 82A in a lower surface 81a of the base material 81. Specifically, the repair process includes a repair etching mask formation step of forming a repair etching mask 86 having mask openings 87a with the repaired hole diameter d2 at portions corresponding to all the holes 82 in the base material 81; a repair etching step of etching the base material 81 through the repair etching mask 86; and a repair mask removal step of removing the repair etching mask 86.

First, the repair etching mask formation step is carried out.

As illustrated in FIG. 16, at the repair etching mask formation step, a photoresist film 87 is formed on the lower surface 81a of the base material 81. This may be the photoresist film 85 formed on the bottom of base material 81, as discussed above. Then, the photoresist film 87 is exposed to light from underneath using a repairing photo mask 93 having circular light-exposing patterns with the repaired hole diameter d2 in the portions corresponding to the holes 82. After that, the photoresist film 87 is developed to turn the photoresist film 87 into the repair etching mask 86 having the circular mask openings 87a with the repaired hole diameter d2 corresponding to the nozzle holes 63, as illustrated in FIG. 17. Residual portion 83 projects from the inside of the mask opening 87a.

Next, the repair etching step is carried out.

As illustrated in FIG. 18, at the repair etching step, the base material 81 is etched with the repair etching mask 86. At the repair etching step, anisotropic etching is carried out using a dry etching technique. Accordingly, it is possible to remove the residual portion 83 in the nozzle holes 63 seen from underneath without having to process the portion of the defective hole 82A other than the residual portion 83.

Next, the repair mask removal step is carried out.

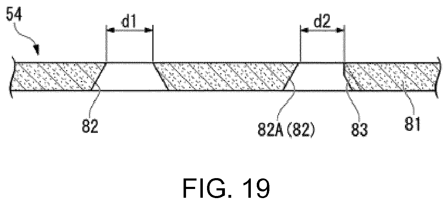

As illustrated in FIG. 19, at the repair mask removal step, the photoresist film 87 constituting the repair etching mask 86 is removed.

Accordingly, the repair process is completed.

In the method for manufacturing the nozzle plate 54 of the embodiment, the repair process includes the repair etching mask formation step of forming the repair etching mask 86 having the mask openings 87a with the repaired hole diameter d2 corresponding to all the holes 82 in the base material 81 and the repair etching step of etching the base material 81 through the repair etching mask 86. According to this method, the base material 81 is etched through the repair etching mask 86 having the mask openings 87a with the repaired hole diameter d2, which makes it possible to repair the defective hole 82A in such a manner as to bring the hole diameter of the portion to be the downstream opening of the defective hole 82A closer to the desired hole diameter d1. Therefore, variations in the hole diameter among the nozzle holes 63 can be reduced.

The method for manufacturing the nozzle plate 54 of the embodiment may include the inspection process in the method for manufacturing the nozzle plate 54 according to the first embodiment. In this case, the repair process is carried out only when the defective hole 82A is detected in the inspection process. This improves the manufacturing efficiency as compared to the method by which the repair process is carried out regardless of the presence or absence of the defective hole 82A.

In the embodiment, the repair etching step is carried out by dry etching. However, the present invention is not limited to this and the repair etching step may be carried out by wet etching.

The present invention is not limited to the foregoing embodiments described above with reference to the drawings but various modifications can be conceived within the technical scope of the present invention as defined by the claims.

For example, in the foregoing embodiments, the hole making process and the repair process are carried out by laser processing, or the hole making process and the repair process are carried out by etching. However, the present invention is not limited to this. Specifically, the hole making process may be carried out by laser processing and the repair process may be carried out by etching. Alternatively, the hole making process may be carried out by etching and the repair process may be carried out by laser processing. Other processes can also be used.

In the foregoing embodiments, out of piezo inkjet heads, wall bend-type inkjet heads are used. However, the present invention is not limited to this configuration. For example, the present invention may be applied to, out of piezo inkjet heads, roof shoot-type inkjet heads (the direction of pressure application to inks and the direction of ink droplet discharge are the same) or other piezo inkjet heads.

In addition, the present invention is not limited to piezo inkjet heads but is also applicable to thermal inkjet heads and others.

In foregoing embodiments, the edge shoot-type inkjet heads are used. However, the present invention is not limited to this. For example, the present invention may be applied to edge shoot-type inkjet heads that discharge inks from the centers of the discharge channels along the extending direction.

Besides, the components of the foregoing embodiments can be substituted with other known components without deviating from the scope of the present invention as appropriate.

## Claims

1. A method for manufacturing an ejection hole plate (54) with ejection holes (63) for ejecting a liquid, comprising:
a hole making process for making a plurality of holes (72, 82) to be the ejection holes in a base material (71, 81) for the ejection hole plate; and
a repair process for repairing a defective hole (72A, 82A) out of the plurality of holes, in which a hole diameter of a portion to be a downstream opening along a flow direction of the liquid is smaller than a desired hole diameter (d1), wherein
in the repair process, the defective hole is processed to have a hole with a repaired hole diameter (d2) of the portion to be the downstream opening smaller than the desired hole diameter and larger than the hole diameter of the defective hole.

2. The method for manufacturing an ejection hole plate according to claim 1, wherein the hole making process and the repair process are carried out by laser processing.

3. The method for manufacturing an ejection hole plate according to claim 1 or 2, wherein, in the repair process, the base material is irradiated with laser light (L2) as parallel beams.

4. The method for manufacturing an ejection hole plate according to claim 1 or 2, wherein, in the repair process, the base material is irradiated from a downstream side in the flow direction with laser light (L3) of which beam diameter gradually increases toward a downstream side in a direction of beam emission.

5. The method for manufacturing an ejection hole plate according to claim 1, wherein
the repair process includes:
a repair etching mask formation step of forming a repair etching mask (86) having a mask opening (87a) with the repaired hole diameter at a portion corresponding to the defective hole in the base material; and
a repair etching step of etching the base material through the repair etching mask.

6. The method for manufacturing an ejection hole plate according to any one of the preceding claims, comprising an inspection process for detecting the defective hole between the hole making process and the repair process.
